(19) Europäisches Patentamt
European Patent Office
Office européen des brevets

(11) **EP 0 594 922 B1**

(12) **EUROPEAN PATENT SPECIFICATION**

(45) Date of publication and mention
of the grant of the patent:
**04.08.1999 Bulletin 1999/31**

(51) Int Cl.⁶: **H04M 1/60**, H03H 7/00

(21) Application number: **92830603.4**

(22) Date of filing: **30.10.1992**

(54) **AC integrated coupler with phase equalizer**

Integrierte Kopplungsschaltung für Wechselstrom mit Phasenausgleich

Circuit intégré de couplage alternatif avec égalisation de phase

(84) Designated Contracting States:
**DE FR GB IT**

(43) Date of publication of application:
**04.05.1994 Bulletin 1994/18**

(73) Proprietor: **STMicroelectronics S.r.l.**
**20041 Agrate Brianza MI (IT)**

(72) Inventors:
• **Tomasini, Luciano**
  **I-20052 Monza (Mi) (IT)**
• **Castello, Rinaldo**
  **I-20043 Arcore (Mi) (IT)**

(74) Representative: **Botti, Mario**
**Botti & Ferrari S.r.l.**
**Via Locatelli, 5**
**20124 Milano (IT)**

(56) References cited:
**US-A- 4 801 888**

• **IEEE JOURNAL OF SOLID STATE CIRCUITS vol. 26, no. 7, July 1991, NEW YORK pages 1015 - 1026 DIELACHER ET AL 'A SOFTWARE PROGRAMMABLE CMOS TELEPHONE CIRCUIT'**

**Description**

This invention relates to alternating current coupling circuits (AC couplers), particularly to such AC couplers as are useful in telephone integrated circuit applications.

Many transmission system circuits require that an AC coupling be established with the outside world owing to problems of DC incompatibility between the external signal and the working point of the various nodes within the circuits.

An AC coupler, additionally to holding back the DC signal, is to admit the AC signal through unaffected in the frequency band of interest (in general, a constant attenuation with the frequency may be tolerated).

The transfer function of an AC coupler is, therefore, of the high-pass type with one or more zeroes at the origin.

In the instance of telephone circuits, the band of interest begins at 300 Hz.

Accordingly, the coupler poles are to be much less than 300 Hz (usually close to 1 Hz), in order to have a negligible error in the band of interest.

The availability of an alternating current coupling circuit which conforms with the specifications of different telephone companies without the use of external components is an essential condition to the provision of new speech circuits which is cost-effective and reliable.

Current art solutions provide for the use of discrete components external of the coupling circuit where this can be integrated monolithically.

An AC coupler having a frequency response with a pole at a frequency on the order of one Hertz is typically implemented with an external capacitor of some tens of μF and an internal resistance on the order of tens of kiloOhms.

The use of external components lowers the degree of reliability and raises costs.

Additionally thereto, the AC coupling is to take place in some cases between internal blocks of the integrated circuit.

In such a case, besides the external component, two additional pins are also required.

In any case, the presence of an external capacitor involves a further disadvantage, in that upon turning on the circuit, a charge current of at least a few mA's is required to attain steady-state voltage at the external capacitor within a short time.

An example of telephone circuit having new features which offer a flexible solution for the different international requirements with only a few external components is discosed in the IEEE JOURNAL OF SOLID STATE CIRCUITS vol. 26, no. 7, July 1991, NEW YORK, pages 1015-1026 DIELATCHER ET AL. "A SOFTWARE PROGRAMMABLE CMOS TELEPHONE CIRCUIT".

It is an object of this invention to provide an AC coupling circuit which has all its components integrated monolithically.

Another object of the invention is to ensure "high-pass" operation with greatly reduced phase error in the transfer function and excellent overall accuracy.

These objects are achieved by an AC coupling circuit as defined in the characterizing parts of Claims 1, 3 and 6.

The features and advantages of a coupling circuit according to the invention will be apparent from the following detailed description of embodiments thereof, given by way of example and not of limitation in the accompanying drawings.

In the drawings:

- Figure 1 is a diagram showing in principle an AC coupling circuit adapted to provide a transfer function wherein by suitable introduction of a doublet, i. e. a pole and a zero at near-coincident frequencies, the phase error can be significantly reduced, that is the phase can be "equalized";

- Figure 2 shows circuitry for implementing the basic diagram by a conventional switched-capacitor technique; and;

- Figure 3 shows improved implementation circuitry using the same technique.

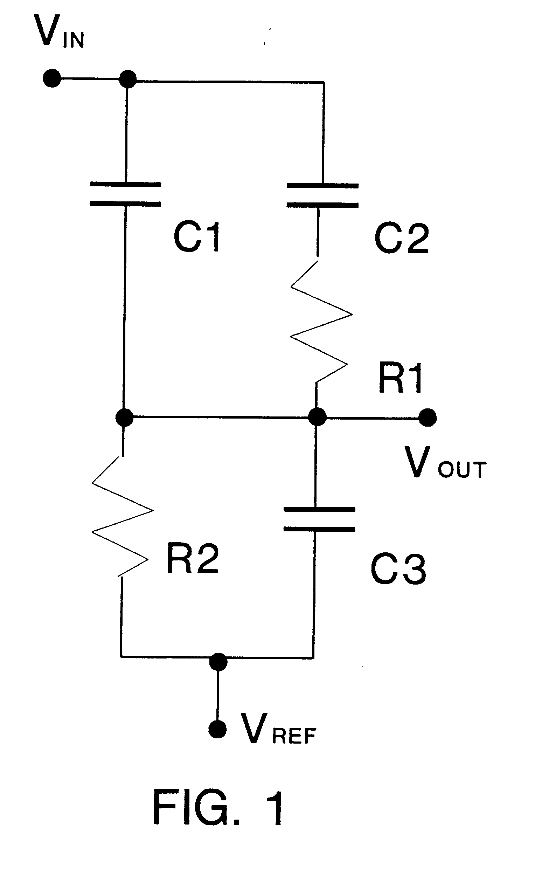

The circuit shown diagramatically in Figure 1 comprises a capacitor C1 connected between an input terminal Vin and an output terminal Vout.

Connected in parallel with this capacitor and serially together are a capacitor C2 and a resistor R1.

A capacitor C3 and a resistor R2 in parallel with each other are connected between the output terminal Vout and a terminal Vref for connection to a reference potential, e.g. to ground.

If the frequency fe is the lower extreme of the signal band of interest in the high-pass mode of the coupling circuit, then the maximum error in the transfer function is:

$$E = [H(\infty) - H(fe)]/H(\infty)$$

where $H(\infty)$ is the value of the transfer function at a high frequency (ideally, infinite frequency) and $H(fe)$ is the value of the transfer function in the pole at frequency fe.

That error is due to the presence of the zero at the origin and to the pole at frequency f1.

As the skilled one in the art will readily recognize, the circuit of Figure 1 introduces a pole/zero doublet which is localized at a frequency f2, higher than f1 but lower than the frequency of the band of interest, that is lower than fe.

In the instance of a telephone speech circuit, fe would be 300 Hz.

Therefore, to obtain an error of less than 0.3%, f1 should be a lower frequency than 1 Hz.

On the other hand, by introducing, in accordance with this invention, a doublet at a frequency f2=50 Hz, with a doublet distance d=0.2 (where d=fzero-fpole), the same error can be obtained with a pole at a frequency f1=10 Hz.

Thus, with a coupling circuit according to the invention, whose transfer function includes a pole/zero doublet, the first pole of the transfer function may be shifted upwards in frequency by a factor of 10 compared to embodiments with no doublet.

A circuit according to the invention can, therefore, be fully integrated monolithically by virtue of the ample saving in silicon area that such a factor affords to an integrated circuit implementation.

Actually, the integration of the circuit shown in Figure 1 is not so convenient.

In order to provide integrated time constants of large value concurrent with good accuracy, a viable scheme is that of using the so-called switched-capacitor technique.

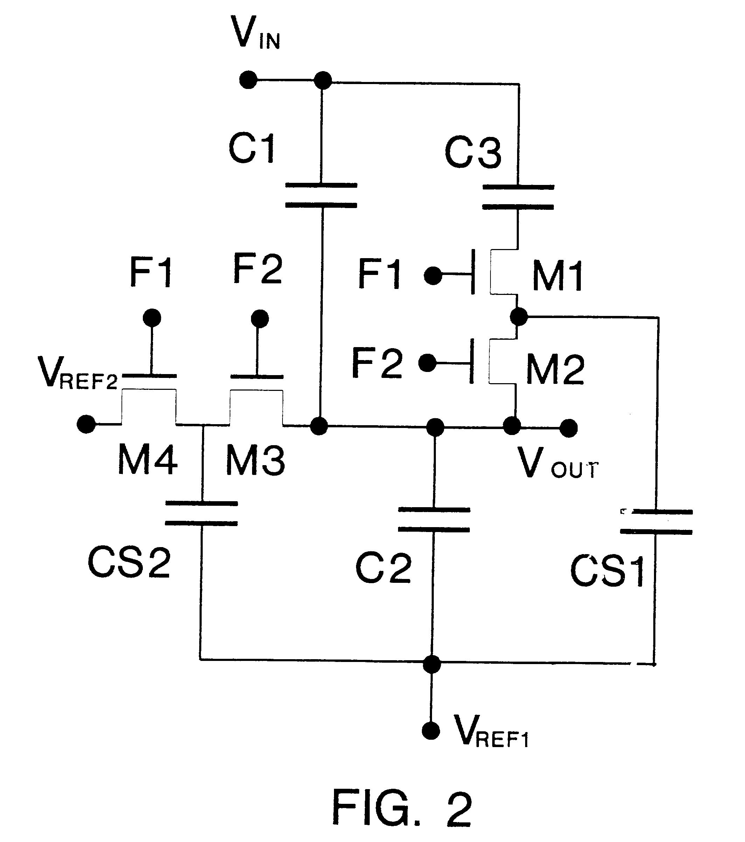

Shown in Figure 2 is a circuit diagram for an AC coupler according to the invention which can be implemented in the switched-capacitor form.

This scheme, unlike that shown in Figure 1, provides -- for reasons inherent to applications of the telephone type -- two discrete terminals of connection to a reference potential, Vref1 and Vref2.

Both these terminals may, however, be connected to the same reference potential, e.g. to ground.

The scheme comprises two capacitors, C1 and C2, which are respectively connected between an input terminal Vin and an output terminal Vout, and between said output terminal and the first terminal, Vref1, of connection to a reference potential.

Connected serially together and in parallel with the capacitor C1 are a capacitor C3 and two field-effect transistors M1 and M2.

Two more field-effect transistors, M3 and M4, are connected between the output terminal Vout and the second terminal, Vref2, of connection to a reference potential.

The connection nodes between the transistors M1 and M2, and between the transistors M3 and M4, are coupled through capacitors Cs1 and Cs2, respectively, to the first terminal, Vref1, of connection to a reference potential.

In accordance with the switched-capacitor technique, the gate terminals of each transistor pair are applied control signals F1 and F2 generated by a control signal generator at two non-overlapping time phases, which signals may be also referred to as clock signals, usually at a frequency of 64 kHz in telephone applications.

Typical capacitance values are C1=30 pF, C2=60 pF, C3=20 pF and Cs1=Cs2=100 pF.

Optimum matching of the frequencies involved can be achieved using switched-capacitor techniques.

In addition, optimum accuracy of the input/output gain value can be provided using high capacitances.

A practical problem encountered with the solution shown in Figure 2 is that the transistors M1 and M2 are connected to the voltage Vin through the capacitor C3 which represents a short circuit in the band of interest.

For this reason, the signal applied to the terminal Vin is transferred to the connection node between the capacitor C3 and the transistor M1.

Thus, said node has a wide dynamic range and requires that high clock voltages be used for it to operate properly.

This poses some difficulties where the voltage supply to the chip is derived from the line (with long lines, this voltage supply may be as high as 2.5 Volts).

A further problem is that upon turning on, the node value may become equal to Vin (12 Vmax), and this voltage cannot be accepted by MOS devices having a maximum operating voltage of 5 Volts.

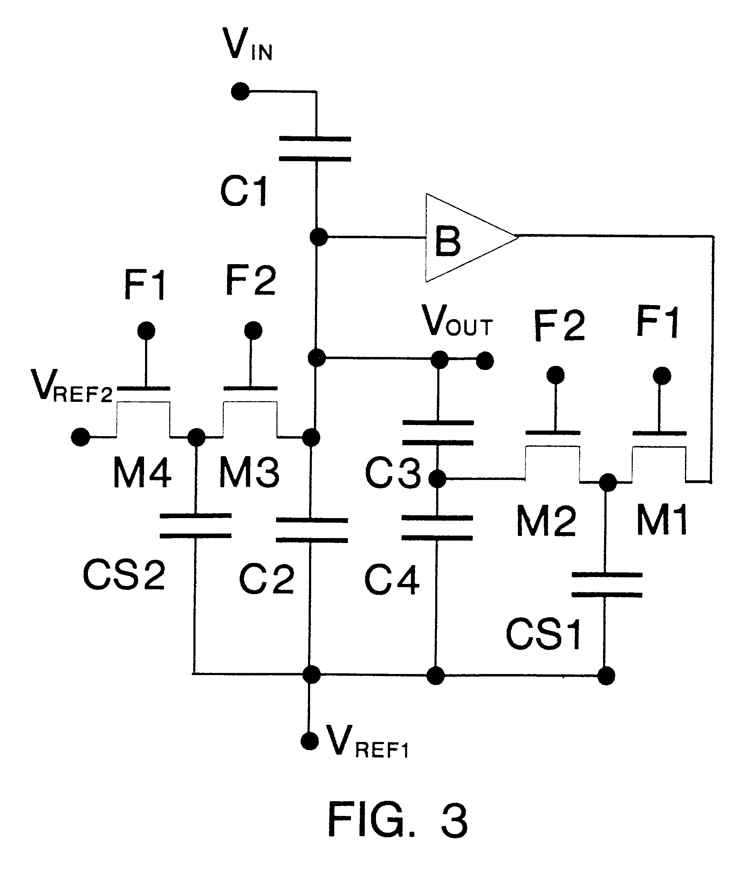

Shown in Figure 3 is the circuit diagram of an AC coupler according to the invention, which can also obviate these drawbacks, but at the expense of a slight increase in integration area.

Compared to the circuit of Figure 2, a unitary gain AC interface circuit means B replaces the capacitor C3 and, unlike the latter, is connected between the output terminal Vout and the transistor pair M1, M2.

The scheme of Figure 3 further comprises a capacitor C4, connected in series with the capacitor C3 between the output terminal and the terminal Vref1 of connection to a reference potential.

The transistor pair M1, M2 are connected here to a connection node between the capacitor C3 and C4.

The advantage of these novel solutions is that all the MOS devices are connected therein to lower voltages than the voltage at the connection node between the capacitors C1 and C2.

Using C1=(1/3) C2, the signal on the node is approximately one fourth the signal Vin.

On this account, the dynamic range required of the clock driving the gates of the MOS's is much reduced.

Additionally, upon turning on, the transistors at Vin (line) appear to be reduced by a factor of four on account of the capacitive divider.

Thus, by limiting the dynamic range of Vin at 12 Volts (using a Zener), the dynamic range on the node can be set at 4 Volts.

This voltage is consistent with the specifications of MOS transistors.

It is understood that the circuits described and illustrated in the foregoing may be altered and modified without departing from the scope of this invention.

## Claims

1. An AC coupling and DC uncoupling circuit, characterized in that it has a transfer function with a pole and a zero at like frequencies provided between a first pole and the frequency band of interest to compensate for the phase error produced by said first pole.

2. An AC coupling and DC uncoupling circuit according to claim 1 having at least one input terminal (Vin) and one output terminal (Vout), and at least first (Vref1) and second (Vref2) terminals of connection to a reference potential, characterized in that it comprises first (C1) and second (C2) capacitive elements connected serially together, respectively between the input terminal (Vin) and the output terminal (Vout), and between said output terminal and the first terminal (Vref1) of connection to a reference potential, that it comprises a third capacitive element (C3) and first and second field-effect transistors (M1,M2) being connected in series, through their respective source and drain terminals, with said third capacitive element (C3) between the input terminal and the output terminal (Vout), and that it comprises third and fourth field-effect transistors (M3.M4) connected serially together, through their respective source and drain terminals, between the output terminal (Vout) and the second terminal (Vref2) of connection to a reference potential, the connection nodes between the first and second transistors (M1,M2), and between the third and fourth transistors (M3,M4), being coupled through capacitive elements (CS1,CS2) to the first terminal (Vref1) of connection to a reference potential, and the gate terminals of said transistors being adapted for connection to a control signal generator with two non-overlapping phases.

3. An AC coupling and DC uncoupling circuit according to Claim 2, characterized in that the capacitive elements are integrated monolithically to the circuit itself.

4. An AC coupling and DC uncoupling circuit according to Claim 3, characterized in that the first and fourth transistors (M1,M4) are driven by control signals whose phase does not overlap that of control signals driving the second and third transistors (M2,M3).

5. An AC coupling and DC uncoupling circuit according to claim 1 having at least one input terminal (Vin) and one output terminal (Vout), and at least first (Vref1) and second (Vref2) terminals of connection to a reference potential, characterized in that it comprises first (C1) and second (C2) capacitive elements connected serially together, respectively between the input terminal (Vin) and the output terminal (Vout) and between the output terminal (Vout) and the first terminal (Vref1) of connection to a reference potential, and at least one unitary gain AC interface circuit means (B), and third (C3) and fourth (C4) capacitive elements connected serially together and in parallel with the second capacitive element (C2), that it comprises at least first and second field-effect transistors (M1,M2) connected serially together through their respective source and drain terminals between a connection circuit node of the third (C3) and fourth (C4) capacitive elements and an output terminal of the interface circuit means (B), having an input terminal connected to the output terminal of the circuit, and at least third and fourth field-effect transistors (M3,M4) connected serially together through their respective source and drain terminals between the output terminal (Vout) and the second terminal (Vref2) of connection to a reference potential, a connection circuit node of the first and second transistors (M1,M2) and a connection circuit node of the third and fourth transistors (M3,M4) being coupled through capacitive elements (CS1,CS2) to the first terminal of connection to a reference potential (Vref) and the gate terminals of said transistors (M1,M2,M3,M4) being adapted for connection to a control signal generator with two non-overlapping phases.

6. An AC coupling and DC uncoupling circuit according to Claim 5, characterized in that the capacitive elements are integrated monolithically to the circuit itself.

7. An AC coupling and DC uncoupling circuit according to Claim 6, characterized in that the first and fourth transistors (M1,M4) are driven by control signals whose phase does not overlap that of control signals driving the second and third transistors (M2,M3).

## Patentansprüche

1. Wechselstrom-Koppel- und Gleichstrom-Entkoppel-Schaltung, dadurch gekennzeichnet, daß sie eine Übertragungsfunktion mit einem Pol und einer Nullstelle bei ähnlichen Frequenzen zwischen einem ersten Pol und dem interessierenden Frequenzband für die Kompensation des durch den ersten Pol erzeugten Phasenfehlers aufweist.

2. Schaltung nach Anspruch 1, mit mindestens einem Eingangsanschluß (Vin) und einem Ausgangsanschluß (Vout) und mindestens einem ersten (Vref1) und einem zweiten (Vref2) Anschluß für die Verbindung mit einem Referenzpotential, dadurch gekennzeichnet, daß sie aufweist: ein erstes (C1) und ein zweites (C2) kapazitives Element, die in Reihe zusammengeschaltet sind zwischen dem Eingangsanschluß (Vin) und dem Ausgangsanschluß (Vout) bzw. zwischen dem Ausgangsanschluß und dem ersten Anschluß (Vref1) für die Verbindung mit einem Referenzpotential, daß sie ein drittes kapazitives Element (C3) und einen ersten und einen zweiten Feldeffekttransistor (M1, M2), die über ihre Source- und Drain-Anschlüsse geschaltet sind, aufweist, wobei das dritte kapazitive Element (C3) zwischen den Eingangsanschluß und den Ausgangsanschluß (Vout) geschaltet ist, und daß sie einen dritten und einen vierten Feldeffekttransistor (M3, M4) aufweist, die in Reihe über ihre Source- und Drainanschlüsse zusammengeschaltet sind zwischen dem Ausgangsanschluß (Vout) und dem zweiten Anschluß (Vref2) für den Anschluß an ein Referenzpotential, wobei die Verbindungsknoten zwischen dem ersten und dem zweiten Transistor (M1, M2) und zwischen dem dritten und dem vierten Transistor (M3, M4) über kapazitive Elemente (CS1, CS2) an den ersten Anschluß (Vref1) für den Anschluß an ein Referenzpotential angeschlossen sind, und die Gate-Anschlüsse der Transistoren für den Anschluß an einen Steuersignalgenerator mit zwei nicht einander überlappenden Phasen ausgebildet sind.

3. Schaltung nach Anspruch 2, dadurch gekennzeichnet, daß die kapazitiven Elemente selbst monolithisch in der Schaltung integriert sind.

4. Schaltung nach Anspruch 3, dadurch gekennzeichnet, daß der erste und der vierte Transistor (M1, M4) von Steuersignalen angesteuert werden, deren Phase sich nicht mit derjenigen der den zweiten und den dritten Transistor (M2, M3) ansteuernden Steuersignale überlappt.

5. Schaltung nach Anspruch 1 mit mindestens einem Eingangsanschluß (Vin) und einem Ausgangsanschluß (Vout), und mindestens einem ersten (Vref1) und einem zweiten (Vref2) Anschluß für die Verbindung mit einem Referenzpotential, dadurch gekennzeichnet, daß sie ein erstes (C1) und ein zweites (C2) kapazitives Element enthält, die in Reihe zusammengeschaltet sind zwischen dem Eingangsanschluß (Vin) und dem Ausgangsanschluß (Vout) bzw. zwischen dem Ausgangsanschluß (Vout) und dem ersten Anschluß (Vref1) für die Verbindung mit einem Referenzpotential, und mindestens eine Wechselstrom-Schnittstellenschaltung (B) mit der Verstärkung von eins aufweist, sowie ein drittes (C3) und ein viertes (C4) kapazitives Element, die in Reihe zusammengeschaltet sind und parallel zu dem zweiten kapazitiven Element (C2) geschaltet sind, daß sie mindestens einen ersten und einen zweiten Feldeffekttransistor (M1, M2) enthält, die in Reihe über ihre Source- und Drainanschlüsse zusammengeschaltet sind zwischen einem Verbindungsschaltungsknoten des dritten (C3) und des vierten (C4) kapazitiven Elements und einem Ausgangsanschluß der Schnittstellenschaltung (B), die mit einem Eingangsanschluß an den Ausgangsanschluß der Schaltung angeschlossen ist, und mindestens einen dritten und einen vierten Feldeffekttransistor (M3, M4), die über ihre Source- und Drainanschlüsse in Reihe geschaltet sind zwischen den Ausgangsanschluß (Vout) und dem zweiten Anschluß (Vref2) für die Verbindung mit einem Referenzpotential, wobei ein Verbindungsschaltungsknoten des ersten und des zweiten Transistors (M1, M2) und ein Verbindungsschaltungsknoten des dritten und des vierten Transistors (M3, M4) über kapazitive Elemente (CS1, CS2) an den ersten Anschluß für die Verbindung mit einem Referenzpotential (Vref) gekoppelt sind, und die Gateanschlüsse der Transistoren (M1, M2, M3, M4) ausgebildet sind für den Anschluß an einen Steuersignalgenerator, der zwei nicht-überlappende Phasen aufweist.

6. Schaltung nach Anspruch 5, dadurch gekennzeichnet, daß die kapazitiven Elemente in der Schaltung selbst monolithisch integriert sind.

7. Schaltung nach Anspruch 6, dadurch gekennzeichnet, daß der erste und der vierte Transistor (M1, M4) von Steuersignalen angesteuert werden, deren Phase sich nicht überlappt mit derjenigen der Steuersignale, die den zweiten und den dritten Transistor (M2, M3) ansteuert.

**Revendications**

1. Un circuit de couplage en courant alternatif et de découplage en courant continu, caractérisé en ce qu'il a une fonction de transfert avec un pôle et un zéro aux mêmes fréquences produites entre un premier pôle et la bande de fréquence à considérer pour compenser l'erreur de phase produite par ledit premier pôle.

2. Un circuit de couplage en courant alternatif et de découplage en courant continu selon la revendication 1, comportant au moins une borne d'entrée (Vin) et une borne de sortie (Vout), et au moins des première (Vref1) et seconde (Vref2) bornes de connexion à un potentiel de référence, caractérisé en ce qu'il comprend des premier (C1) et second (C2) éléments capacitifs connectés ensemble en série, respectivement entre la borne d'entrée (Vin) et la borne de sortie (Vout), et entre ladite borne de sortie et la première borne (Vref1) de connexion à un potentiel de référence, en ce qu'il comprend un troisième élément capacitif (C3) et des premier et second transistors à effet de champ (M1, M2) qui sont connectés en série, par l'intermédiaire de leurs bornes de source et de drain respectives, ledit troisième élément capacitif (C3) se trouvant entre la borne d'entrée et la borne de sortie (Vout), et en ce qu'il comprend des troisième et quatrième transistors à effet de champ (M3, M4) connectés ensemble en série, par l'intermédiaire de leurs bornes de source et de drain respectives, entre la borne de sortie (Vout) et la seconde borne (Vref2) de connexion à un potentiel de référence, les noeuds de connexion entre les premier et second transistors (M1, M2), et entre les troisième et quatrième transistors (M3, M4) étant couplés par l'intermédiaire d'éléments capacitifs (CS1, CS2) à la première borne (Vref1) de connexion à un potentiel de référence, et les bornes de grille desdits transistors étant adaptées pour être connectées à un générateur de signal de commande avec deux phases non-recouvrantes.

3. Un circuit de couplage en courant alternatif et de découplage en courant continu selon la revendication 2, caractérisé en ce que les éléments capacitifs sont intégrés de façon monolithique dans le circuit lui-même.

4. Un circuit de couplage en courant alternatif et de découplage en courant continu selon la revendication 3, caractérisé en ce que les premier et quatrième transistors (M1, M4) sont pilotés par des signaux de commande dont les phases ne recouvrent pas celle des signaux de commande pilotant les second et troisième transistors (M2, M3).

5. Un circuit de couplage en courant alternatif et de découplage en courant continu selon la revendication 1, comportant au moins une borne d'entrée (Vin) et une borne de sortie (Vout), et au moins des première (Vref1) et seconde (Vref2) bornes de connexion à un potentiel de référence, caractérisé en ce qu'il comprend des premier (C1) et second (C2) éléments capacitifs connectés ensemble en série, respectivement entre la borne d'entrée (Vin) et la borne de sortie (Vout) et entre la borne de sortie (Vout) et la première borne (Vref1) de connexion à un potentiel de référence, et au moins un circuit d'interface en courant alternatif à gain unité (B), et des troisième (C3) et quatrième (C4) éléments capacitifs connectés ensemble en série et en parallèle avec le second élément capacitif (C2), en ce qu'il comprend au moins des premier et second transistors à effet de champ (M1, M2) connectés ensemble en série par l'intermédiaire de leurs bornes de source et de drain respectives entre un noeud de circuit de connexion des troisième (C3) et quatrième (C4) éléments capacitifs et une borne de sortie du circuit d'interface (B), ayant une borne d'entrée connectée à la borne de sortie du circuit, et au moins des troisième et quatrième transistors à effet de champ (M3, M4) connectés ensemble en série par l'intermédiaire de leurs bornes de source et de drain respectives entre la borne de sortie (Vout) et la seconde borne (Vref2) de connexion à un potentiel de référence, un noeud de circuit de connexion des premier et second transistors (M1, M2) et un noeud de circuit de connexion des troisième et quatrième transistors (M3, M4) étant couplés par l'intermédiaire d'éléments capacitifs (CS1, CS2) à la première borne de connexion à un potentiel de référence, et les bornes de grille desdits transistors (M1, M2, M3, M4) étant adaptées pour être connectées à un générateur de signal de commande avec deux phases non-recouvrantes.

6. Un circuit de couplage en courant alternatif et de découplage en courant continu selon la revendication 5, caractérisé en ce que les éléments capacitifs sont intégrés de façon monolithique au circuit lui-même.

7. Un circuit de couplage en courant alternatif et de découplage en courant continu selon la revendication 6, caractérisé en ce que les premier et quatrième transistors (M1, M4) sont pilotés par des signaux de commande dont la phase ne recouvre pas celle des signaux de commande pilotant les second et troisième transistors (M2, M3).

$V_{IN}$

C1

C2

R1

$V_{OUT}$

R2

C3

$V_{REF}$

# FIG. 1

FIG. 2

FIG. 3